# EUROPEAN PATENT APPLICATION

(11) **EP 4 531 282 A1**
(43) Date of publication of application: **02.04.2025**
(21) Application number: 24185907.3
(22) Date of filing: 02.07.2024
(51) Int. Cl.: H03F 1/42, H03F 3/195, H03F 1/22

(54) **WIDEBAND CHANNEL SELECTIVE AMPLIFIER STRUCTURES**

(30) Priority: 29.09.2023 US 202318374696
(71) Applicant: INTEL Corporation, Santa Clara, CA 95054 (US)
(72) Inventor: RAVI, Ashoke, Portland, 97219 (US); DEGANI, Ofir, 22801 Nes-Ammin (IL); KRISHNAMURTHY, Sashank, Hillsboro, 97124 (US); GUPTA, Soumya, Corvallis, 97330 (US)
(74) Representative: Viering, Jentschura & Partner mbB Patent- und Rechtsanwälte

(57) **Abstract**

An amplifier structure may include a first amplifier substructure having a first amplifier and a first filter structure and provide a first high frequency output signal and a first low frequency output signal having a frequency lower than a frequency of the first high frequency output signal. It may include a second amplifier substructure having a second amplifier and a second filter structure and provide a second high frequency output signal and a second low frequency output signal having a frequency lower than the frequency of the second high frequency output signal. It may include a first combination node configured to receive the first high frequency output signal and the second low frequency output signal and to provide a first amplified signal, and a second combination node configured to receive the first low frequency output signal and the second high frequency output signal and to provide a second amplified signal.

## Description

### Technical Field

Various aspects of this disclosure relate generally to amplifier structures, e.g. to wideband channel selective amplifier structures.

### Background

To allow for increased data rates, and multiple device simultaneous connections, conventional communication systems employ a simultaneous working multi radio (MiMo and Carrier Aggregation) and multi-protocol links. To this end, each operation frequency band and communication protocol typically requires a separate transceiver tuned to the respective operation frequency band (e.g. WiFi has 2.5 GHz and 5 GHz to 7 GHz operation frequency bands), which in turn results in increased area, cost and complexity of connections to antennas. Moreover, operating simultaneous frequency carriers in the same frequency band of operation requires expensive off-chip filtering components (e.g. bulk acoustic wave (BAW) filters / surface acoustic wave (SAW) filters), to reject the chip-internally generated blockers.

A conventional component is a resistive feedback wideband low noise amplifier (LNA); however, these LNAs have no selectivity and suffer from compression due to strong blockers (even chip-external ones). Channel-selective wideband mixer first topologies suffer from very high noise figure.

### Brief Description of the Drawings

In the drawings, like reference characters generally refer to the same parts throughout the different views. The drawings are not necessarily to scale, emphasis instead generally being placed upon illustrating the principles of the invention. In the following description, various embodiments of the invention are described with reference to the following drawings, in which:
FIG. 1 shows an exemplary amplifier structure in accordance with various aspects of this disclosure;
FIG. 2 shows a circuit illustrating the effect of a correlated noise suppression;
FIG. 3 shows a simplified version of the amplifier structure of FIG. 1;
FIGS. 4A and 4B show noise characteristics for the circuits as shown in FIG. 2 and FIG. 3;
FIGS. 5A and 5B show transistor level simulation results for the amplifier structure as shown in FIG. 1;
FIG. 6 shows a simplified version of an amplifier structure for a four frequency N-path filter in accordance with various aspects of this disclosure; and
FIG. 7 shows an exemplary amplifier structure in accordance with various aspects of this disclosure.

### Description

The following detailed description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

The word "over" used with regards to a deposited material formed "over" a side or surface, may be used herein to mean that the deposited material may be formed "directly on", e.g. in direct contact with, the implied side or surface. The word "over" used with regards to a deposited material formed "over" a side or surface, may be used herein to mean that the deposited material may be formed "indirectly on" the implied side or surface with one or more additional layers being arranged between the implied side or surface and the deposited material.

Various aspects of this disclosure provide a wide-band low noise amplifier that also has built-in filter capabilities that can be tuned to any desired channel center frequency and bandwidth according to a desired communication protocol. This allows a profound cost saving due to reduced circuit area, aggregating all tuned LNAs into one common tuned LNA, and the elimination of the costly off-chip components.

Various aspects of this disclosure illustratively provide an inverter-based wideband transconductance stage with source follower driven resistive feedback followed by a common gate, channel-selective transimpedance stage based on N-path staggered tuned mixer circuits. The topology according to various aspects of this disclosure enjoys very good and competitive noise figure at its input to any tuned LNA. Moreover, it enjoys superior linearity over conventional tuned LNAs. The LNA according to various aspects of this disclosure may allow for channel center frequency selectivity over DC-8 GHz bandwidth with channel bandwidth tuning as well. An implementation shows a profound area reduction compared to even a single tuned LNA, while aggregating the operation of multiple of them.

An amplifier structure according to various aspects may have only exactly one (single) chip port for operation of multiple frequency bands (in contrast to a convention chip which usually has multiple chip ports, one chip port for each frequency band of operation expected), in other words only a single chip port may be provided for all frequency bands per communication protocol.

Various aspects provide an amplifier structure providing
a) wideband operation (e.g. DC up to 8 GHz),
b) low-noise,
c) high channel-selectivity and
d) low area demand on a chip.

Illustratively, an amplifier structure may achieve the same using a wideband transconductance stage driving a multi-frequency staggered N-path-filter based channel-selective common-gate transimpedance stage.

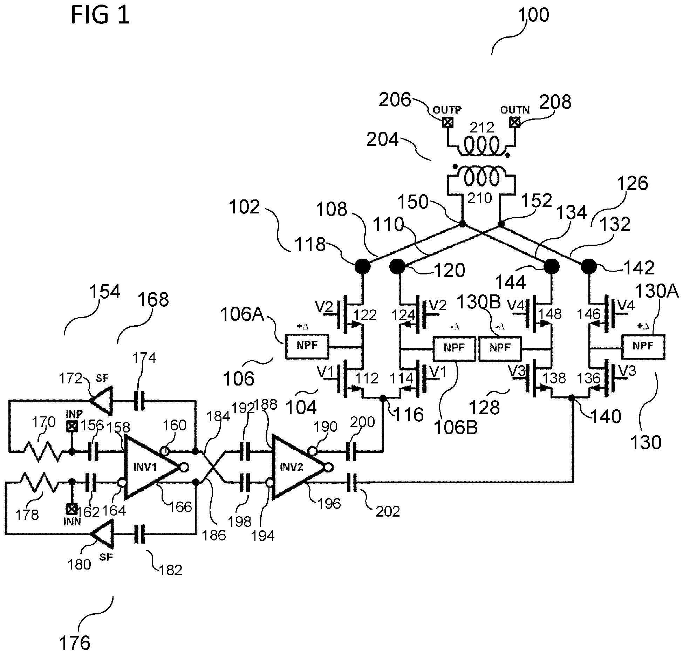

FIG. 1 shows an amplifier structure 100 in accordance with various aspects of this disclosure. Illustratively, FIG. 1 shows a wideband channel selective LNA topology in accordance with various aspects of this disclosure. The amplifier structure 100 may include a first amplifier substructure 102 having a first amplifier 104 and a first filter structure 106. The amplifier structure 100 may be configured to provide a first high frequency output signal 108 and a first low frequency output signal 110 having a frequency lower than the frequency of the first high frequency output signal 110. Illustratively, the first high frequency output signal 108 and the first low frequency output signal 110 may be understood as a bandpass filter response centered at two different frequencies dependent on the filter characteristic of the first filter structure 106.

The first amplifier 104 may include a first transistor 112 and a second transistor 114 configured and connected to form the first amplifier 104 as a differential amplifier. The first transistor 112 and the second transistor 114 may be p-channel field effect transistors (FETs), e.g. p-channel metal oxide semiconductor (MOS) FETs. A first controlled terminal (e.g. source) of the first transistor 112 is coupled to a first controlled terminal (e.g. source) of the second transistor 114 (e.g. at a first node 116). A second controlled terminal (e.g. drain) of the first transistor 112 may be (directly or indirectly) coupled to a first terminal 118 providing the first high frequency output signal 108, and a second controlled terminal (e.g. drain) of the second transistor 114 may be (directly or indirectly) coupled to a second terminal 120 providing the first low frequency output signal 110. A first control voltage V1, which may be lower than the supply voltage (e.g. VDD), e.g. lower than half of the supply voltage, e.g. in the range from about 0.2 * VDD to 0.4 * VDD, e.g. 1/3 VDD, may be applied to a control terminal (e.g. gate) of the first transistor 112 and/or to a control terminal (e.g. gate) of the second transistor 114.

The first amplifier 104 optionally may further include a first cascode transistor 122 coupled to the first transistor 112 and a second cascode transistor 124 coupled to the second transistor 114. The first cascode transistor 122 and the second cascode transistor 124 may be p-channel FETs, e.g. p-channel MOSFETs. A first controlled terminal (e.g. drain) of the first cascode transistor 122 may be (e.g. directly) coupled to the second controlled terminal (e.g. source) of the first transistor 112. A second controlled terminal (e.g. source) of the first cascode transistor 122 may be (e.g. directly) coupled to the first terminal 118. Furthermore, a first controlled terminal (e.g. drain) of the second cascode transistor 124 may be (e.g. directly) coupled to the second controlled terminal (e.g. source) of the second transistor 114. A second controlled terminal (e.g. source) of the second cascode transistor 124 may be (e.g. directly) coupled to the second terminal 120. A second control voltage V2, which may also be lower than the supply voltage (e.g. VDD), e.g. lower than the supply voltage but higher than half of the supply voltage, e.g. in the range from about 0.6 * VDD to 0.8 * VDD, e.g. 2/3 VDD, may be applied to a control terminal (e.g. gate) of the first cascode transistor 122 and/or to a control terminal (e.g. gate) of the second cascode transistor 124. The first amplifier 104 may be configured in a common gate structure.

The first filter structure 106 may further include a first filter 106A coupled to the second controlled terminal of the first transistor 112. In case the first cascode transistor 122 is provided, the first filter 106A may be coupled between the first transistor 112 and the first cascode transistor 122. Furthermore, the first amplifier 104 may further include a second filter 106B coupled to the second controlled terminal of the second transistor 114. In case the second cascode transistor 124 is provided, the second filter 106B may be coupled between the second transistor 114 and the second cascode transistor 124.

The first filter 106A and the second filter 106B may have various configurations, such as an LC filter configuration, a bandpass shunt filter configuration, or an N-path filter configuration. The first filter 106A, e.g. a first N-path filter 106A, may have a first center frequency f_{c1}. The first center frequency f_{c1} may be smaller than a predefined frequency f_{LO}. The second filter 106B, e.g. a second N-path filter 106B, may have a second center frequency f_{c2}. The second center frequency f_{c2} may be higher than the predefined frequency f_{LO}. Thus, the second center frequency f_{c2} may be higher than the first center frequency f_{c1}. The first center frequency f_{c1} and the second center frequency f_{c2} may be symmetrically offset from the predefined frequency f_{LO} by the same frequency value, e.g. a first frequency value, e.g. denoted with Δf₁ (i.e., e.g. f_{c1} = f_{LO} + Δf₁ and f_{c2} = f_{LO} - Δf₁). Illustratively, the transistors (which may also be understood as switches in this case) of the first filter 106A, e.g. the first N-path filter 106A, may be driven by a signal having the first center frequency f_{c1}, and the transistors (which may also be understood as switches in this case) of the second filter 106B, e.g. the second N-path filter 106B, may be driven by a further signal having the second center frequency f_{c2}.

The amplifier structure 100 may further include a second amplifier substructure 126 having a second amplifier 128 and a second filter structure 130. The amplifier structure 100 may be configured to provide a second high frequency output signal 132 and a second low frequency output signal 134 having a frequency lower than the frequency of the second high frequency output signal 132.

The second amplifier 128 may include a third transistor 136 and a fourth transistor 138 configured and connected to form the second amplifier 128 as a differential amplifier. The third transistor 136 and the fourth transistor 138 may be p-channel FETs, e.g. p-channel MOSFETs. A first controlled terminal (e.g. source) of the third transistor 136 is coupled to a first controlled terminal (e.g. source) of the fourth transistor 138 (e.g. at a second node 140). A second controlled terminal (e.g. drain) of the third transistor 136 may be (directly or indirectly) coupled to a third terminal 142 providing the second high frequency output signal 132, and a second controlled terminal (e.g. drain) of the fourth transistor 138 may be (directly or indirectly) coupled to a fourth terminal 144 providing the second low frequency output signal 134. A third control voltage V3, which may be lower than the supply voltage (e.g. VDD), e.g. lower than half of the supply voltage, e.g. in the range from about 0.2 * VDD to 0.4 * VDD, e.g. 1/3 VDD, may be applied to a control terminal (e.g. gate) of the third transistor 136 and/or to a control terminal (e.g. gate) of the fourth transistor 138.

The second amplifier 128 optionally may further include a third cascode transistor 146 coupled to the third transistor 136 and a fourth cascode transistor 148 coupled to the fourth transistor 138. The third cascode transistor 146 and the fourth cascode transistor 148 may be p-channel FETs, e.g. p-channel MOSFETs. A first controlled terminal (e.g. drain) of the third cascode transistor 146 may be (e.g. directly) coupled to the second controlled terminal (e.g. source) of the third transistor 136. A second controlled terminal (e.g. source) of the third cascode transistor 146 may be (e.g. directly) coupled to the third terminal 142. Furthermore, a first controlled terminal (e.g. drain) of the fourth cascode transistor 148 may be (e.g. directly) coupled to the second controlled terminal (e.g. source) of the fourth transistor 138. A second controlled terminal (e.g. source) of the fourth cascode transistor 148 may be (e.g. directly) coupled to the fourth terminal 144. A fourth control voltage V4, which may also be lower than the supply voltage (e.g. VDD), e.g. lower than the supply voltage but higher than half of the supply voltage, e.g. in the range from about 0.6 * VDD to 0.8 * VDD, e.g. 2/3 VDD, may be applied to a control terminal (e.g. gate) of the third cascode transistor 146 and/or to a control terminal (e.g. gate) of the fourth cascode transistor 148. The second amplifier 128 may be configured in a common gate structure.

The second filter structure 130 may further include a third filter 130A coupled to the second controlled terminal of the third transistor 136. In case the third cascode transistor 146 is provided, the third filter 130A may be coupled between the third transistor 136 and the third cascode transistor 146. Furthermore, the second amplifier 128 may further include a fourth filter 130B coupled to the second controlled terminal of the fourth transistor 138. In case the fourth cascode transistor 148 is provided, the fourth filter 130B may be coupled between the fourth transistor 138 and the fourth cascode transistor 148.

The third filter 130A and the fourth filter 130B may have various configurations, such as an LC filter configuration, a bandpass shunt filter configuration, or an N-path filter configuration. The third filter 130A, e.g. a third N-path filter 130A, may have a third center frequency f_{c3}, which is identical to the first center frequency f_{c1}. The third center frequency f_{c3} may be smaller than the predefined frequency f_{LO}. The fourth filter 130B, e.g. a fourth N-path filter 130B, may have a fourth center frequency f_{c4}, which is identical to the second center frequency f_{c2}. The fourth center frequency f_{c4} may be higher than the predefined frequency f_{LO}. Thus, the fourth center frequency f_{c4} may be higher than the third center frequency f_{c3}. The third center frequency f_{c3} and the fourth center frequency f_{c4} may be symmetrically offset from the predefined frequency f_{LO} by the same frequency value, e.g. the first frequency value, e.g. denoted with Δf₁ (i.e., e.g. f_{c3} = f_{LO} + Δf₁ and f_{c4} = f_{LO} - Δf₁).

The first amplifier substructure 102 and the second amplifier substructure 126 may have the same structure, e.g. the same electronic components which may be connected in the same connection structure. Furthermore, the first frequency value and the second frequency value may have the same frequency value, e.g. a common frequency value Δf (i.e., e.g. Δf= Δf₁ = Δf₂).

The amplifier structure 100 may further include a first combination node 150 configured to receive the first high frequency output signal 108 (e.g. having the first center frequency f_{c1}, e.g. f_{c1} = f_{LO} + Δf₁) and the second low frequency output signal 134 (e.g. having the fourth center frequency f_{c4}, e.g. f_{c4} = f_{LO} - Δf) and to provide a first amplified signal, which may be the sum of the first high frequency output signal 108 and the second low frequency output signal 134. In other words, the first transistor 112 (or the first cascode transistor 122) and the fourth transistor 138 (or the fourth cascode transistor 148) provide the first amplified signal at the first combination node 150. The amplifier structure 100 may further include a second combination node 152 configured to receive the first low frequency output signal 110 (e.g. having the second center frequency f_{c2}, e.g. f_{c2} = f_{LO} - Δf) and the second high frequency output signal 132 (e.g. having the third center frequency f_{c3}, e.g. f_{c3} = f_{LO} + Δf) and to provide a second amplified signal, which may be the sum of the first low frequency output signal 110 and the second high frequency output signal 132. In other words, the second transistor 114 (or the second cascode transistor 124) and the third transistor 136 (or the third cascode transistor 146) provide the second amplified signal at the second combination node 152.

The amplifier structure 100 may further include an input circuit 154 coupled to the first amplifier substructure 102 and the second amplifier substructure 126.

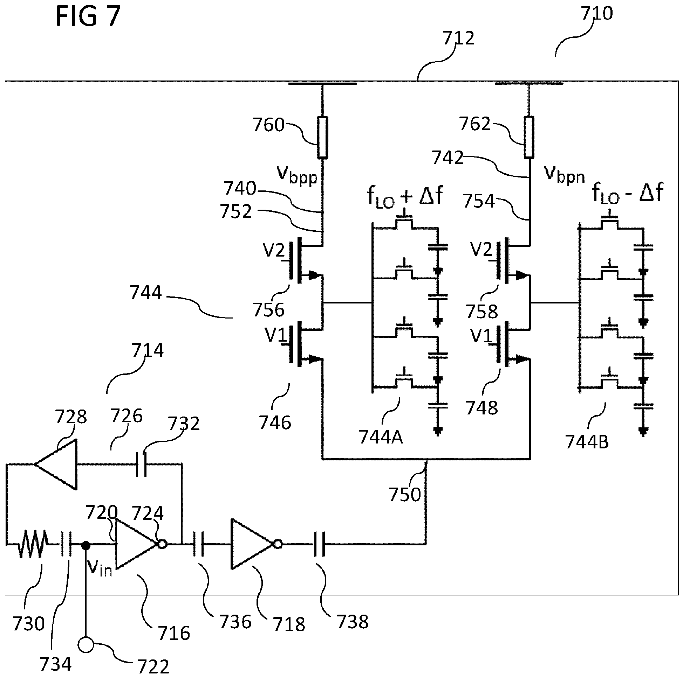

It is to be noted that the input circuit 154 may also be provided independent from the specific structure of the rest of the amplifier structure, e.g. the input circuit 154 may be provided to a different amplifier circuit as compared to the first amplifier substructure 104 and the second amplifier substructure 126. By way of example, the input circuit 154 may also be provided as a single ended input circuit 154 together with a differential amplifier structure, as will be explained in more detail below and as shown in FIG. 7).

The input circuit 154 may include a series connection of a first inverter stage INV1 and a second inverter stage INV2. The first inverter stage INV1 may be configured to receive a first input voltage V_{INP} (e.g. at a first input INP of the input circuit 154) of a differential input voltage pair V_{INP}, V_{INN} and a second input voltage V_{INN} (e.g. at a second input INN of the input circuit 154) of the differential input voltage pair V_{INP}, V_{INN}. As will be explained in more detail below, illustratively, the first inverter stage INV1 sets an impedance matching for low noise and the second inverter stage INV2 drives the amplifier substructure(s) 102, 126, e.g. the cascode stack(s) with sufficient current.

The first inverter stage INV1 may further be configured to provide an intermediate differential voltage pair Vᵢₙₜ₁, Vᵢₙₜ₂ to inputs of the second inverter stage INV2. An optional first capacitor 156 (which blocks the DC portion of the first input voltage V_{INP}) may be connected between the first input INP of the input circuit 154 and a first input 158 of the first inverter stage INV1. The first inverter stage INV1 further includes a first output 160 and is configured to invert the signal received at the first input 158 and to provide the inverted received signal (e.g. an inverted first input voltage, e.g. without the DC signal portion of the first input voltage V_{INP}) as a first intermediate voltage 184 at the first output 160. An optional second capacitor 162 (which blocks the DC portion of the second input voltage V_{INN}) may be connected between the second input INN of the input circuit 154 and a second input 164 of the first inverter stage INV1. The first inverter stage INV1 further includes a second output 166 and is configured to invert the signal received at the second input 164 and to provide the inverted received signal (e.g. an inverted second input voltage, e.g. without the DC signal portion of the second input voltage V_{INN}) as a second intermediate voltage 186 at the second output 160.

The input circuit 154 may further include a feedback structure, which may couple an output of the first inverter stage INV1 to a corresponding input of the first inverter stage INV1. By way of example, the feedback structure may include one or more feedback paths, each feedback path coupling an output of the first inverter stage INV1 to a corresponding input of the first inverter stage INV1.

A first feedback path 168 may couple the first output 160 of the first inverter stage INV1 back with the first input 158 of the first inverter stage INV1. The first feedback path 168 may include a first resistor 170, which may be coupled between the first output 160 of the first inverter stage INV1 and the first input 158 of the first inverter stage INV1, e.g. between the first output 160 of the first inverter stage INV1 and the first capacitor 156. Furthermore, the first feedback path 168 may include a first source follower circuit SF 172 coupled in series between the first output 160 of the first inverter stage INV1 and the first resistor 170, thereby forming a series connection with the first resistor 170. Optionally, a third capacitor 174 may be connected between the first output 160 of the first inverter stage INV1 and an input of the first source follower circuit SF 172 (or, in case the first source follower circuit SF 172 is not present, between the first output 160 of the first inverter stage INV1 and the first resistor 170).

A second feedback path 176 may couple the second output 166 of the first inverter stage INV1 back with the second input 164 of the first inverter stage INV1. The second feedback path 176 may include a second resistor 178, which may be coupled between the second output 166 of the first inverter stage INV1 and the second input 164 of the first inverter stage INV1, e.g. between the second output 166 of the first inverter stage INV1 and the second capacitor 162. Furthermore, the second feedback path 176 may include a second source follower circuit SF 180 coupled in series between the second output 166 of the first inverter stage INV1 and the second resistor 178, thereby forming a series connection with the second resistor 178. Optionally, a fourth capacitor 182 may be connected between the second output 166 of the first inverter stage INV1 and an input of the second source follower circuit SF 180 (or, in case the second source follower circuit SF 180 is not present, between the second output 166 of the first inverter stage INV1 and the second resistor 178).

The second inverter stage INV2 may include at least one output and at least one input and is configured to invert a signal received at the at least one input and provide the inverted signal at the at least one output. By way of example, the second inverter stage INV2 may include a first input 188 and a first output 190. The first input 188 of the second inverter stage INV2 may be (directly or indirectly, e.g. via a fifth capacitor 192) coupled with the second output 166 of the first inverter stage INV1 and may be configured to invert the received second intermediate voltage 186 provided by the first inverter stage INV1.

The second inverter stage INV2 may further include a second input 194 and a second output 196. The second input 196 of the second inverter stage INV2 may be (directly or indirectly, e.g. via a sixth capacitor 198) coupled with the first output 160 of the first inverter stage INV1 and may be configured to invert the received first intermediate voltage 184 provided by the first inverter stage INV1. An output of the second inverter stage INV2 may be coupled to the first amplifier substructure 102 and the second amplifier substructure 126. By way of example, the first output 190 of the second inverter stage INV2 may be (directly or indirectly, e.g. via a seventh capacitor 200) coupled with the first node 116, and the second output 196 of the second inverter stage INV2 may be (directly or indirectly, e.g. via an eighth capacitor 202) coupled with the second node 140.

The amplifier structure 100 may optionally further include a transformer 204 and a first output 206 and a second output 208. The transformer 204 thus galvanically decouples the combination nodes 150, 152 (which are arranged on the primary side of the transformer 204) from the outputs 206, 208 of the amplifier structure 100 (which are arranged on the secondary side of the transformer 204). The transformer 204 may include a primary coil 210, a first terminal of which is (directly or indirectly) coupled with the first combination node 150 and a second terminal of which is (directly or indirectly) coupled with the second combination node 152.

The transformer 204 may further include a secondary coil 212, a first terminal of which is (directly or indirectly) coupled with the first output 206 and a second terminal of which is (directly or indirectly) coupled with the second output 208. The transformer 204 transfers the voltage difference between the first combination node 150 and the second combination node 152 to the secondary side of the transformer 204 and output the transferred voltage difference (V_{OUTP} - V_{OUTN}) at the outputs 206, 208 as an amplified output voltage.

This implementation of an exemplary wideband transconductance circuit as shown in FIG. 1 uses two inverter stages, namely the first inverter stage INV1 and the second inverter stage INV2. For broadband impedance matching, the resistive feedback architecture is provided, e.g. the feedback path(s) of the input circuit 154. As shown in FIG. 1, the feedback is not from the output(s) (e.g. first output 190 and second output 196) of the second inverter INV2 due to the low gain of the common-gate stage (e.g. first amplifier 104 and/or the second amplifier 128) driven by the second inverter stage INV2. It may be provided to place a feedback resistor (e.g. the first resistor 170 or the second resistor 178) around an amplifier with high gain and low output impedance. There is a significant power penalty to reduce the output impedance of the first inverter stage INV1. Therefore, this implementation places the feedback resistor (e.g. the first resistor 170 or the second resistor 178) around the amplifier (of the first inverter stage INV1) followed by a source follower stage, e.g. formed by the first source follower circuit 172 and/or the second source follower circuit 180). Channel selectivity may be achieved using e.g. a staggered N-path filter technique. An N-path filter driven at the predefined frequency f_{LO}, illustratively yields a first order bandpass response centered at the predefined frequency f_{LO}. If the responses of two N-path filters, which are centered at symmetrical offset frequencies ±Δf from e.g. the predefined frequency f_{LO} are combined anti-phase, the resultant response may be a second order bandpass response centered at e.g. the predefined frequency f_{LO}. Placing these N-path filters (e.g. the first filter 106A and the second filter 106B or the third filter 130A and the fourth filter 130B) at the cascode node of the common-gate stage (as shown in FIG. 1) isolates the interaction between the two N-path filters, yielding a combination of the two N-path responses with reduced noise. A voltage combination or a current combination may be used to combine the responses of the two branches, namely of the first amplifier substructure 102 and of the second amplifier substructure 126. An output match in the amplifier structure of FIG. 1 may be provided using a low-Q transformer matching network which maintains the wideband operation of the proposed circuit. The architecture as shown in FIG. 1 may provide correlated noise suppression in addition to the effect of a resultant higher-order response.

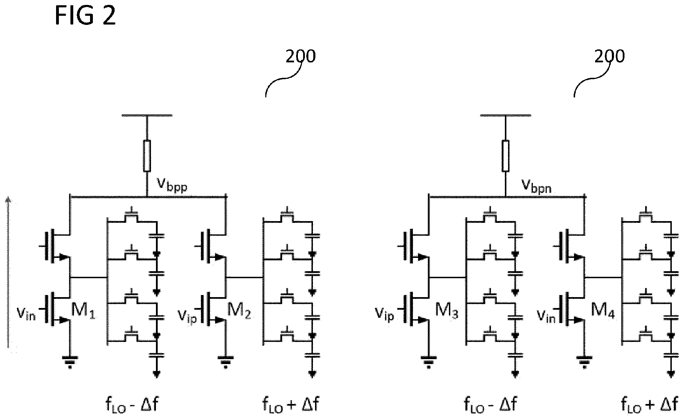

The effect of a correlated noise suppression is illustrated by the circuits in FIG. 2. A common-source amplifier 200 as shown in FIG. 2 is a conventional implementation of an LNA with embedded staggered N-path filters. In other words, FIG. 2 shows a common-source LNA with staggered N-path filtering embedded in a cascode node.

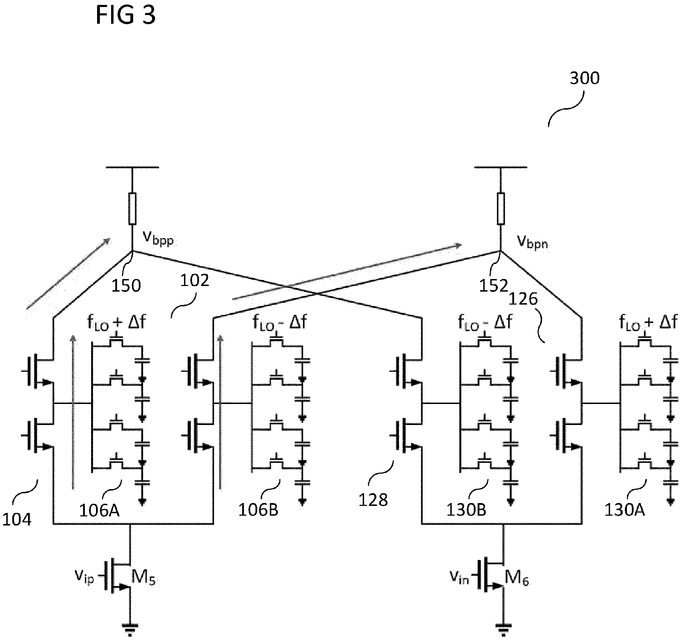

FIG. 3 is a simplified version 300 of the amplifier structure 100 of FIG. 1 where the wideband transconductance stage (e.g. the input circuit 154) is replaced by a single transistor for convenience of explanation. Consider the noise of the common source transistor M5 in FIG. 3. The noise propagates to both the positive and negative output voltages Vbpp and Vbpn and is shaped appropriately by two different N-path filters (e.g. the first filter 106A and the second filter 106B or the third filter 130A and the fourth filter 130B). When the differential output is considered, the noise from the common source transistor M5 gets suppressed since it appears at both the outputs (e.g. first terminal 118 and second terminal 120) in a correlated fashion. The same holds true for another common source transistor M6 in FIG. 3. However, it is to be considered that the noise of the common source transistors M1-M4 for the alternative circuit in FIG. 2, no such correlated suppression effect is observed. Illustratively, FIG. 3 shows a transconductance driving a common gate transimpedance stage with N-path filtering embedded in a cascode node.

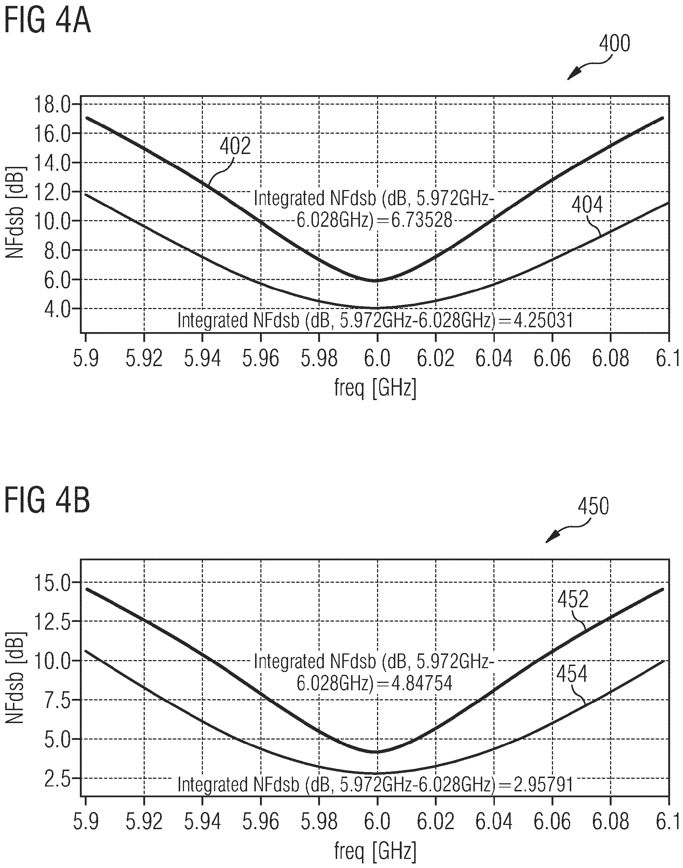

This is illustrated by a simulation using ideal voltage controlled current sources to model the different transistors and appropriate noise modeling of the common source transistors M1-M4 in FIG. 2 and of the common source transistors M5, M6 in FIG. 3 as shown in FIG. 4A and FIG. 4B. For an iso-power comparison, the effective transconductance of the transistors M1-M4 in FIG. 2 is one half the effective transconductance of the transistors M5, M6 in FIG. 3. The noise figure (for a 100-ohm differential source impedance) is shown for the two architectures in FIG. 2 and FIG. 3 in FIG. 4A and FIG. 4B for two different values of transistor transconductance (FIG. 4A shows a first simulation diagram 400 for the a first value of transistor transconductance for the circuits shown in FIG. 2 and FIG. 3 and FIG. 4B shows a second simulation diagram 450 for the a second value of transistor transconductance for the circuits shown in FIG. 2 and FIG. 3). The noise suppression effect is shown for the architecture shown in FIG. 3. It is to be noted that the filter-signal response for both the circuits was identical by design.

A first characteristic 402 in the first simulation diagram 400 of FIG. 4A represents a noise over frequency characteristic for the circuit 200 of FIG. 2 having a transconductance (gm) value of the common-source transistors M1 to M4 of 10 mS. A second characteristic 404 in the first simulation diagram 400 of FIG. 4A represents a noise over frequency characteristic for the circuit 300 of FIG. 3 having a transconductance (gm) value of the common-source transistors M5 and M6 of 20 mS. The power consumption in this case is kept the same for both circuits 200, 300.

A first characteristic 452 in the second simulation diagram 450 of FIG. 4B represents a noise over frequency characteristic for the circuit 200 of FIG. 2 having a transconductance (gm) value of the common-source transistors M1 to M4 of 20 mS. A second characteristic 454 in the second simulation diagram 450 of FIG. 4B represents a noise over frequency characteristic for the circuit 300 of FIG. 3 having a transconductance (gm) value of the common-source transistors M5 and M6 of 40 mS. The power consumption in this case is kept the same for both circuits 200, 300.

In all cases, the filter response of both circuits 200, 300 is maintained identical with a bandwidth of 56 MHz around 6 GHz and a second order roll-off. Clearly, the noise characteristics 404, 454 for the circuit 300 of FIG. 3 is lower for the same power consumption, illustrating the correlated noise suppression benefit in the topology according to various aspects of this disclosure.

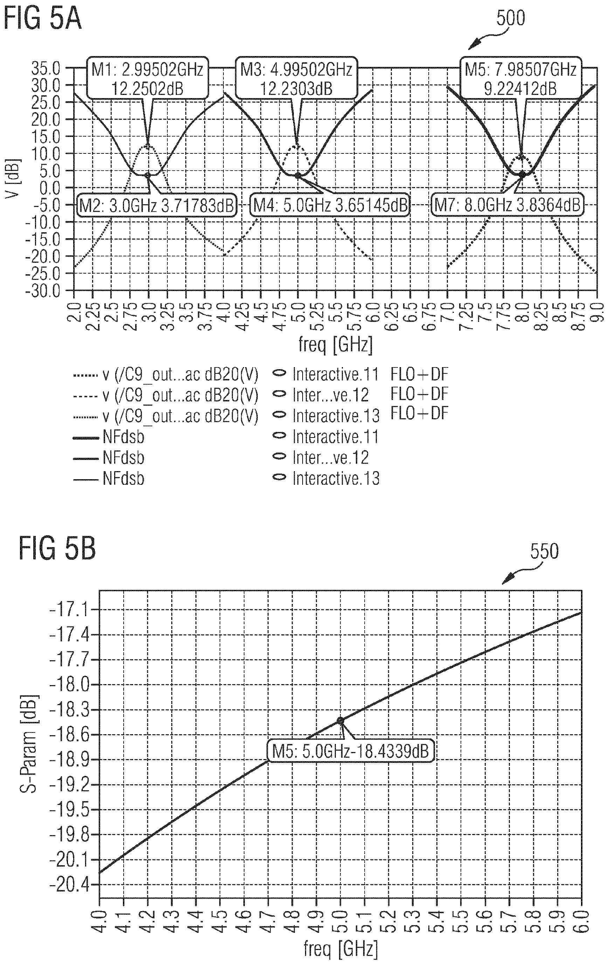

FIG. 5A and FIG. 5B show transistor level simulation results of the amplifier structure 100 of FIG. 1. Wideband operation up to 8GHz is illustrated with the gain at 8GHz only 3dB lower than the gain at lower frequencies of operation in a gain versus frequency diagram 500. The tunable second order filter response is also shown. The amplifier structure 100 achieves an in-band input P1dB of -15dBm. Additionally, the core area is a tiny 0.025 mm² (see diagram 550 of FIG. 5B) with an output transformer occupying an additional 0.01 mm². To summarize, the amplifier structure 100 can meet the system requirements of
a) wideband operation,
b) low-noise,
c) high channel selectivity, and
d) low area.

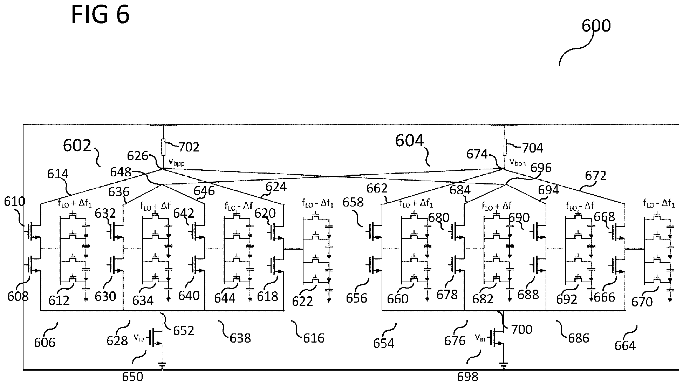

FIG. 6 shows an example amplifier structure 600 for a four frequency N-path filter.

The amplifier structure 600 includes a first partial amplifier structure 602 and a second partial amplifier structure 604.

The first partial amplifier structure 602 may include a first amplifier substructure 606 having a series connection of a first amplifier transistor 608 and a first cascode transistor 610. The first partial amplifier structure 602 may further include a first filter 612 connected to a cascode node, in other words connected to a node between the first amplifier transistor 608 and the first cascode transistor 610. The first filter 612 may be a first N-path filter 612 and may have a first center frequency f_{c1}. The first center frequency f_{c1} may be offset from a predefined frequency f_{LO} by a first frequency value, e.g. denoted with Δf₁ (i.e., e.g. f_{c1} = f_{LO} + Δf₁). The first amplifier substructure 606 may be coupled to a first terminal 614 and may be configured to provide a first high frequency output signal at the first terminal 614.

The first partial amplifier structure 602 may further include a second amplifier substructure 616 having a series connection of a second amplifier transistor 618 and a second cascode transistor 620. The first partial amplifier structure 602 may further include a second filter 616 connected to a cascode node, in other words connected to a node between the second amplifier transistor 618 and the second cascode transistor 620. The second filter 622 may be a second N-path filter 622 and may have a second center frequency f_{c2}. The second center frequency f_{c2} may be offset from the predefined frequency f_{LO} by a second frequency value (which may be equal to the first frequency value), e.g. denoted with Δf₁ (i.e., e.g. f_{c2} = f_{LO} - Δf₁). The second amplifier substructure 616 may be coupled to a second terminal 624 and may be configured to provide a second high frequency output signal at the second terminal 624.

The first terminal 614 and the second terminal 624 may be coupled together at a first common node 626 and may be on the same electrical potential.

The first partial amplifier structure 602 may further include a third amplifier substructure 628 having a series connection of a third amplifier transistor 630 and a third cascode transistor 632. The first partial amplifier structure 602 may further include a third filter 634 connected to a cascode node, in other words connected to a node between the third amplifier transistor 630 and the third cascode transistor 632. The third filter 634 may be a third N-path filter 634 and may have a third center frequency f_{c3}. The third center frequency f_{c3} may be offset from the predefined frequency f_{LO} by a third frequency value (which may be equal to or different from the first frequency value or the second frequency value), e.g. denoted with Δf₃ (i.e., e.g. f_{c3} = f_{LO} + Δf). The third amplifier substructure 628 may be coupled to a third terminal 636 and may be configured to provide a third high frequency output signal at the third terminal 636.

The first partial amplifier structure 602 may further include a fourth amplifier substructure 638 having a series connection of a fourth amplifier transistor 640 and a fourth cascode transistor 642. The first partial amplifier structure 602 may further include a fourth filter 644 connected to a cascode node, in other words connected to a node between the fourth amplifier transistor 640 and the fourth cascode transistor 642. The fourth filter 644 may be a fourth N-path filter 644 and may have a fourth center frequency f_{c4}. The fourth center frequency f_{c4} may be symmetrically offset from the predefined frequency f_{LO} (with respect to the third center frequency f_{c3}) by a fourth frequency value (which may be equal to the third frequency value), e.g. denoted with Δf (i.e., e.g. f_{c4} = f_{LO} - Δf). The fourth amplifier substructure 638 may be coupled to a fourth terminal 646 and may be configured to provide a fourth high frequency output signal at the fourth terminal 646.

The third terminal 636 and the fourth terminal 638 may be coupled together at a second common node 648 and may be on the same electrical potential.

The first partial amplifier structure 602 may further include a current source, e.g. implemented by a first common source transistor 650. The first common source transistor 650 may be connected between a reference potential (e.g. ground potential) and a first partial amplifier structure node 652. The first amplifier transistor 608, the second amplifier transistor 618, the third amplifier transistor 630, and the fourth amplifier transistor 640 are all (e.g. directly) coupled to the first partial amplifier structure node 652.

The second partial amplifier structure 604 may include a fifth amplifier substructure 654 having a series connection of a fifth amplifier transistor 656 and a fifth cascode transistor 658. The second partial amplifier structure 604 may further include a fifth filter 660 connected to a cascode node, in other words connected to a node between the fifth amplifier transistor 656 and the fifth cascode transistor 658. The fifth filter 660 may be a fifth N-path filter 660 and may have a fifth center frequency f_{c5}. The fifth center frequency f_{c5} may be identical to the first center frequency f_{c1}. The fifth center frequency f_{c5} may be offset from the predefined frequency f_{LO} by a fifth frequency value, e.g. denoted with Δf₅ (i.e., e.g. f_{c5} = f_{LO} + Δf₁). The fifth amplifier substructure 654 may be coupled to a fifth terminal 662 and may be configured to provide a fifth high frequency output signal at the fifth terminal 662.

The second partial amplifier structure 604 may further include a sixth amplifier substructure 664 having a series connection of a sixth amplifier transistor 666 and a sixth cascode transistor 668. The second partial amplifier structure 604 may further include a sixth filter 670 connected to a cascode node, in other words connected to a node between the sixth amplifier transistor 666 and the sixth cascode transistor 668. The sixth filter 670 may be a sixth N-path filter 670 and may have a sixth center frequency f_{c6}. The sixth center frequency f_{c6} may be identical to the second center frequency f_{c2}. The sixth center frequency f_{c6} may be offset from the predefined frequency f_{LO} by a sixth frequency value (which may be equal to the fifth frequency value), e.g. denoted with Δf₁ (i.e., e.g. f_{c6} = f_{LO} - Δf₁). The sixth amplifier substructure 664 may be coupled to a sixth terminal 672 and may be configured to provide a sixth high frequency output signal at the sixth terminal 672.

The fifth terminal 662 and the sixth terminal 672 may be coupled together at a third common node 674 and may be on the same electrical potential.

The second partial amplifier structure 604 may further include a seventh amplifier substructure 676 having a series connection of a seventh amplifier transistor 678 and a seventh cascode transistor 680. The second partial amplifier structure 604 may further include a seventh filter 682 connected to a cascode node, in other words connected to a node between the seventh amplifier transistor 678 and the seventh cascode transistor 680. The seventh filter 682 may be a seventh N-path filter 682 and may have a seventh center frequency f_{c7}. The seventh center frequency f_{c7} may be identical to the third center frequency f_{c3}. The seventh center frequency f_{c7} may be offset from the predefined frequency f_{LO} by a seventh frequency value (which may be equal to or different from the fifth frequency value or the sixth frequency value), e.g. denoted with Δf (i.e., e.g. f_{c7} = f_{LO} + Δf). The seventh amplifier substructure 676 may be coupled to a seventh terminal 684 and may be configured to provide a seventh high frequency output signal at the seventh terminal 684.

The second partial amplifier structure 604 may further include an eighth amplifier substructure 686 having a series connection of an eighth amplifier transistor 688 and an eighth cascode transistor 690. The second partial amplifier structure 604 may further include an eighth filter 692 connected to a cascode node, in other words connected to a node between the eighth amplifier transistor 688 and the eighth cascode transistor 690. The eighth filter 692 may be an eighth N-path filter 692 and may have an eighth center frequency f_{c8}. The eighth center frequency f_{c8} may be identical to the fourth center frequency f_{c4}. The eighth center frequency f_{c8} may be symmetrically offset from the predefined frequency f_{LO} (with respect to the seventh center frequency f_{c7}) by an eighth frequency value (which may be equal to the seventh frequency value), e.g. denoted with Δf (i.e., e.g. f_{c8} = f_{LO} - Δf). The eighth amplifier substructure 686 may be coupled to an eighth terminal 694 and may be configured to provide an eighth high frequency output signal at the eighth terminal 694.

The seventh terminal 684 and the eighth terminal 694 may be coupled together at a fourth common node 696 and may be on the same electrical potential.

The second partial amplifier structure 604 may further include a further current source, e.g. implemented by a second common source transistor 698. The second common source transistor 698 may be connected between a reference potential (e.g. ground potential) and a second partial amplifier structure node 700. The fifth amplifier transistor 656, the sixth amplifier transistor 666, the seventh amplifier transistor 678, and the eighth amplifier transistor 688 are all (e.g. directly) coupled to the second partial amplifier structure node 700.

The fourth common node 696 is also (e.g. directly) coupled to the first common node 626 so that the fourth common node 696, the first terminal 614 and the second terminal 624 are all on the same electrical potential. In the simplified structure of FIG. 6, a first load resistor 702 is provided, which is coupled to the first common node 626. The second common node 648 is also (e.g. directly) coupled to the third common node 674 so that the second common node 648, the fifth terminal 662 and the sixth terminal 672 are all on the same electrical potential. In the simplified structure of FIG. 6, a second load resistor 704 is provided, which is coupled to the third common node 674.

The first load resistor 702 and the second load resistor 704 may be replaced by a transformer circuit such as the transformer 204.

FIG. 7 shows an exemplary amplifier structure 710 in accordance with various aspects of this disclosure. The amplifier structure 710 may include a single-ended input circuit 714.

The amplifier structure 710 may include an amplifier circuit 712 and the input circuit 714 coupled upstream to the amplifier circuit 712. The input circuit 714 may include a series connection of a first inverter stage 716 and a second inverter stage 718. The first inverter stage 716 is configured to provide an intermediate voltage to the second inverter stage 718. The first inverter stage 716 may include an input 720 coupled to an input terminal 722 (the input terminal is configured to receive an input voltage Vin), an output 724 coupled to the second inverter stage 718, and a feedback path 726 from the output 724 of the first inverter stage 716 to the input 720 of the first inverter stage 714. The input terminal 722 is configured to receive the input voltage Vin and the feedback path 726 may include a source follower circuit 728 and a resistor 730.

The feedback path 726 may further include a first capacitor 732 coupled between the output 724 of the first inverter stage 716 and an input of the source follower circuit 728. The feedback path 726 may further include a second capacitor 734 coupled between the resistor 730 and the input 720 of the first inverter stage 716. The amplifier structure 710 may further include a third capacitor 736 coupled between the first inverter stage 716 and the second inverter stage 718. The first inverter stage is configured to receive the input voltage Vin and to provide an intermediate voltage to the second inverter stage 718.

The second inverter stage 718 is configured to receive the intermediate voltage, to invert the received intermediate voltage and to provide the inverted intermediate voltage as an amplifier input voltage to the amplifier circuit 712.

The amplifier structure 710 may further include a fourth capacitor 738 coupled between the second inverter stage 718 and the amplifier circuit 712.

In the simplified structure of FIG. 7, the amplifier circuit 712 may be configured to provide a first high frequency output signal 740 and a first low frequency output signal 742 having a frequency lower than the frequency of the first high frequency output signal 740. Illustratively, the first high frequency output signal 740 and the first low frequency output signal 742 may be understood as a bandpass filter response centered at two different frequencies dependent on the filter characteristic of a filter structure 744.

The amplifier structure 712 may include a first transistor 746 and a second transistor 748 configured and connected to form an amplifier as a differential amplifier. The first transistor 746 and the second transistor 748 may be p-channel field effect transistors (FETs), e.g. p-channel metal oxide semiconductor (MOS) FETs. A first controlled terminal (e.g. source) of the first transistor 746 is coupled to a first controlled terminal (e.g. source) of the second transistor 748 (e.g. at a first node 750). An output of the input circuit 714 may also be coupled (e.g. directly) with the first node 750. By way of example, the fourth capacitor 738 may be coupled between an output of the second inverter stage 718 and the first node 750. A second controlled terminal (e.g. drain) of the first transistor 746 may be (directly or indirectly) coupled to a first terminal 752 providing the first high frequency output signal 740, and a second controlled terminal (e.g. drain) of the second transistor 748 may be (directly or indirectly) coupled to a second terminal 754 providing the first low frequency output signal 742. A first control voltage V1, which may be lower than the supply voltage (e.g. VDD), e.g. lower than half of the supply voltage, e.g. in the range from about 0.2 * VDD to 0.4 * VDD, e.g. 1/3 VDD, may be applied to a control terminal (e.g. gate) of the first transistor 746 and/or to a control terminal (e.g. gate) of the second transistor 748.

The amplifier optionally may further include a first cascode transistor 756 coupled to the first transistor 746 and a second cascode transistor 758 coupled to the second transistor 748. The first cascode transistor 756 and the second cascode transistor 758 may be p-channel FETs, e.g. p-channel MOSFETs. A first controlled terminal (e.g. drain) of the first cascode transistor 756 may be (e.g. directly) coupled to the second controlled terminal (e.g. source) of the first transistor 746. A second controlled terminal (e.g. source) of the first cascode transistor 756 may be (e.g. directly) coupled to the first terminal 752. Furthermore, a first controlled terminal (e.g. drain) of the second cascode transistor 758 may be (e.g. directly) coupled to the second controlled terminal (e.g. source) of the second transistor 748. A second controlled terminal (e.g. source) of the second cascode transistor 758 may be (e.g. directly) coupled to the second terminal 754. A second control voltage V2, which may also be lower than the supply voltage (e.g. VDD), e.g. lower than the supply voltage but higher than half of the supply voltage, e.g. in the range from about 0.6 * VDD to 0.8 * VDD, e.g. 2/3 VDD, may be applied to a control terminal (e.g. gate) of the first cascode transistor 756 and/or to a control terminal (e.g. gate) of the second cascode transistor 758. The amplifier may be configured in a common gate structure.

The filter structure 744 may include a first filter 744A coupled to the second controlled terminal of the first transistor 746. In case the first cascode transistor 756 is provided, the first filter 744A may be coupled between the first transistor 746 and the first cascode transistor 756. Furthermore, the amplifier may further include a second filter 744B coupled to the second controlled terminal of the second transistor 748. In case the second cascode transistor 758 is provided, the second filter 744B may be coupled between the second transistor 748 and the second cascode transistor 758.

The first filter 744A and the second filter 744B may have various configurations, such as an LC filter configuration, a bandpass shunt filter configuration, or an N-path filter configuration. The first filter 744A, e.g. a first N-path filter 744A, may have a first center frequency f_{c1'}. The first center frequency f_{c1'} may be smaller than a predefined frequency f_{LO}. The second filter 744B, e.g. a second N-path filter 744B, may have a second center frequency f_{c2'}. The second center frequency f_{c2'} may be higher than the predefined frequency f_{LO}. Thus, the second center frequency f_{c2'} may be higher than the first center frequency f_{c1'}. The first center frequency f_{c1'} and the second center frequency f_{c2'} may be symmetrically offset from the predefined frequency f_{LO} by the same frequency value, e.g. a first frequency value, e.g. denoted with Δf (i.e., e.g. f_{c1'} = f_{LO} + Δf and f_{c2'} = f_{LO} - Δf). Illustratively, the transistors (which may also be understood as switches in this case) of the first filter 744A, e.g. the first N-path filter 744A, may be driven by a signal having the first center frequency f_{c1'}, and the transistors (which may also be understood as switches in this case) of the second filter 744B, e.g. the second N-path filter 744B, may be driven by a further signal having the second center frequency f_{c2'}.

The amplifier structure 710 may further include a first load resistor 760 coupled to the first terminal 752 and a second load resistor 762 coupled to the second terminal 754. The first load resistor 760 and the second load resistor 762 may be replaced by a transformer circuit such as the transformer 204. The amplifier structure 710 may provide a first output voltage Vbpp at the first load resistor 760 and a second output voltage Vbpn at the second load resistor 762.

In the following, various aspects of this disclosure will be illustrated:

Example 1 is an amplifier structure. The amplifier structure may include a first amplifier substructure including a first amplifier and a first filter structure and configured to provide a first high frequency output signal and a first low frequency output signal having a frequency lower than the frequency of the first high frequency output signal; a second amplifier substructure including a second amplifier and a second filter structure and configured to provide a second high frequency output signal and a second low frequency output signal having a frequency lower than the frequency of the second high frequency output signal; a first combination node configured to receive the first high frequency output signal and the second low frequency output signal and to provide a first amplified signal; and a second combination node configured to receive the first low frequency output signal and the second high frequency output signal and to provide a second amplified signal.

In Example 2, the subject matter of Example 1 can optionally include that each of the first amplifier substructure and the second amplifier substructure have a same structure.

In Example 3, the subject matter of any one of Examples 1 or 2 can optionally include that the first amplifier substructure includes a first transistor and a second transistor. A first controlled terminal of the first transistor is coupled to a first controlled terminal of the second transistor. A second controlled terminal of the first transistor is coupled to a first terminal providing the first high frequency output signal, and a second controlled terminal of the second transistor is coupled to a second terminal providing the first low frequency output signal.

In Example 4, the subject matter of any one of Examples 1 to 3 can optionally include that the second amplifier substructure includes a third transistor and a fourth transistor. A first controlled terminal of the third transistor is coupled to a first controlled terminal of the fourth transistor, a second controlled terminal of the third transistor is coupled to a third terminal providing the second high frequency output signal, and a second controlled terminal of the fourth transistor is coupled to a fourth terminal providing the second low frequency output signal.

In Example 5, the subject matter of any one of Examples 3 or 4 can optionally include that the first amplifier further includes a first cascode transistor coupled to the first transistor and a second cascode transistor coupled to the second transistor.

In Example 6, the subject matter of any one of Examples 3 to 5 can optionally include that the second amplifier further includes a third cascode transistor coupled to the third transistor and a fourth cascode transistor coupled to the fourth transistor.

In Example 7, the subject matter of any one of Examples 1 to 6 can optionally include that the first amplifier is configured in a common gate structure.

In Example 8, the subject matter of any one of Examples 1 to 7 can optionally include that the second amplifier is configured in a common gate structure.

In Example 9, the subject matter of any one of Examples 6 to 8 can optionally include that the first amplifier further includes a first cascode transistor coupled to the first transistor and a second cascode transistor coupled to the second transistor; and that the first filter structure includes a first filter coupled between the first transistor and the first cascode transistor and a second filter coupled between the second transistor and the second cascode transistor.

In Example 10, the subject matter of any one of Examples 6 to 9 can optionally include that the second filter structure includes a third filter coupled between the third transistor and the third cascode transistor and a fourth filter coupled between the fourth transistor and the fourth cascode transistor.

In Example 11, the subject matter of any one of Examples 9 or 10 can optionally include that the first filter includes a first N-path filter having a first center frequency, and that the second filter includes a second N-path filter having a second center frequency, the first center frequency being higher than the second center frequency.

In Example 12, the subject matter of any one of Examples 10 or 11 can optionally include that the third filter includes a third N-path filter having a third center frequency, and that the fourth filter includes a fourth N-path filter having a fourth center frequency, the third center frequency being higher than the fourth center frequency.

In Example 13, the subject matter of any one of Examples 11 or 12 can optionally include that the first center frequency and the second center frequency are symmetrically offset from a predefined frequency by the same frequency value.

In Example 14, the subject matter of any one of Examples 11 to 13 can optionally include that the third center frequency and the fourth center frequency are symmetrically offset from a predefined frequency by the same frequency value.

In Example 15, the subject matter of any one of Examples 1 to 14 can optionally include that the amplifier structure further includes an input circuit coupled to the first amplifier substructure and the second amplifier substructure.

In Example 16, the subject matter of any one of Examples 1 to 15 can optionally include that the input circuit includes a series connection of a first inverter stage and a second inverter stage, that the first inverter stage is configured to receive a first input voltage of a differential input voltage pair and a second input voltage of the differential input voltage pair and to provide an intermediate differential voltage pair to the second inverter stage. An output of the second inverter stage is coupled to the first amplifier substructure and the second amplifier substructure.

In Example 17, the subject matter of Example 16 can optionally include that the first inverter stage includes at least one feedback path from a first output of the first inverter stage to a first input of the first inverter stage. The feedback path includes a first resistor.

In Example 18, the subject matter of Example 17 can optionally include that the at least one feedback path includes a series connection of a first source follower circuit and the first resistor.

In Example 19, the subject matter of any one of Examples 16 to 18 can optionally include that the first inverter stage further includes a second feedback path from a second output of the first inverter stage to a second input of the first inverter stage. The second feedback path includes a second resistor.

In Example 20, the subject matter of Example 19 can optionally include that the second feedback path includes a series connection of a second source follower circuit and the second resistor.

In Example 21, the subject matter of any one of Examples 1 to 20 can optionally include that the first filter structure is configured to reduce the noise of the signal received by the first filter structure to provide the first high frequency output signal and the first low frequency output signal.

In Example 22, the subject matter of any one of Examples 1 to 21 can optionally include that the second filter structure is configured to reduce the noise of the signal received by the second filter structure to provide the second high frequency output signal and the second low frequency output signal.

In Example 23, the subject matter of any one of Examples 1 to 22 can optionally include that the first combination node is configured to provide the first amplified signal by suppressing noise by combining the first high frequency output signal and the second low frequency output signal; and that the second combination node is configured to provide the second amplified signal by suppressing noise by combining the second high frequency output signal and the first low frequency output signal.

In Example 24, the subject matter of any one of Examples 1 to 23 can optionally include that the first combination node is configured to provide the first amplified signal by suppressing correlated noise generated in the first amplifier and in the second amplifier; and that the second combination node is configured to provide the second amplified signal by suppressing correlated noise generated in the first amplifier and in the second amplifier.

In Example 25, the subject matter of any one of Examples 1 to 24 can optionally include that the amplifier structure further includes a third amplifier substructure including a third amplifier and a third filter structure and configured to provide a third high frequency output signal and a third low frequency output signal having a frequency lower than the frequency of the third high frequency output signal; and a third combination node configured to receive the first high frequency output signal and the third low frequency output signal and to provide a first amplified signal; or a third combination node configured to receive the first low frequency output signal and the third high frequency output signal and to provide a first amplified signal.

In Example 26, the subject matter of Example 25 can optionally include that the first amplifier substructure, the second amplifier substructure and the third amplifier substructure have the same structure.

In Example 27, the subject matter of any one of Examples 25 or 26 can optionally include that the third amplifier substructure includes a fifth transistor and a sixth transistor. A first controlled terminal of the fifth transistor is coupled to a first controlled terminal of the sixth transistor. A second controlled terminal of the fifth transistor is coupled to a fifth terminal providing the third high frequency output signal. A second controlled terminal of the sixth transistor is coupled to a sixth terminal providing the third low frequency output signal.

In Example 28, the subject matter of any one of Examples 25 to 27 can optionally include that the third amplifier further includes a fifth cascode transistor coupled to the fifth transistor and a sixth cascode transistor coupled to the sixth transistor.

In Example 29, the subject matter of any one of Examples 25 to 28 can optionally include that the third amplifier is configured in a common gate structure.

In Example 30, the subject matter of any one of Examples 25 to 29 can optionally include that the third amplifier further includes a fifth cascode transistor coupled to the fifth transistor and a sixth cascode transistor coupled to the sixth transistor; and that the third filter structure includes a fifth filter coupled between the fifth transistor and the fifth cascode transistor and a sixth filter coupled between the sixth transistor and the sixth cascode transistor.

In Example 31, the subject matter of any one of Examples 25 to 30 can optionally include that the third filter includes a fifth N-path filter having a fifth center frequency, and that the sixth filter includes a sixth N-path filter having a sixth center frequency, the fifth center frequency being higher than the sixth center frequency.

In Example 32, the subject matter of any one of Examples 30 or 31 can optionally include that the fifth center frequency and the sixth center frequency are symmetrically offset from a third predefined frequency by the same frequency value.

Example 33 is an amplifier structure. The amplifier structure may include an amplifier circuit; and an input circuit coupled to the amplifier circuit. The input circuit includes a series connection of a first inverter stage and a second inverter stage. The first inverter stage is configured to provide an intermediate voltage to the second inverter stage. The first inverter stage includes an input coupled to an input terminal, an output coupled to the second inverter stage, and a feedback path from the output of the first inverter stage to the input of the first inverter stage. The input terminal is configured to receive an input voltage, and the feedback path includes a resistor.

In Example 34, the subject matter of Example 33 can optionally include that the feedback path further includes a source follower circuit coupled to the resistor.

In Example 35, the subject matter of Example 34 can optionally include that the feedback path further includes a first capacitor coupled between the output of the first inverter stage and an input of the source follower circuit.

In Example 36, the subject matter of any one of Examples 33 to 35 can optionally include that the feedback path further includes a second capacitor coupled between the resistor and the input of the first inverter stage.

In Example 38, the subject matter of any one of Examples 33 to 36 can optionally include that the amplifier structure further includes a third capacitor coupled between the first inverter stage and the second inverter stage.

In Example 38, the subject matter of any one of Examples 33 to 37 can optionally include that the amplifier circuit includes a differential amplifier circuit configured to receive a first amplifier input voltage of a differential amplifier input voltage pair and a second amplifier input voltage of the differential amplifier input voltage pair.

In Example 39, the subject matter of Example 38 can optionally include that the first inverter stage is configured to receive a first input voltage of a differential input voltage pair and a second input voltage of the differential input voltage pair; and to provide an differential intermediate voltage pair to the second inverter stage. The second inverter stage is configured to receive a first differential intermediate voltage of the differential intermediate voltage pair, to invert the received first differential intermediate voltage and to provide the inverted first differential intermediate voltage as the first amplifier input voltage to the differential amplifier circuit; and to receive a second differential intermediate voltage of the differential intermediate voltage pair, to invert the received second differential intermediate voltage and to provide the inverted second differential intermediate voltage as the second amplifier input voltage to the differential amplifier circuit.

In Example 40, the subject matter of any one of Examples 38 or 39 can optionally include that the first inverter stage further includes a further input coupled to a further input terminal, a further output coupled to the second inverter stage, and a further feedback path from the further output of the first inverter stage to the further input of the first inverter stage. The further input terminal is configured to receive a further input voltage. The further feedback path includes a further source follower circuit and a further resistor.

In Example 41, the subject matter of Example 40 can optionally include that the further feedback path further includes a fourth capacitor coupled between the further output of the first inverter stage and the input of the further source follower circuit.

In Example 42, the subject matter of any one of Examples 40 or 41 can optionally include that the further feedback path further includes a fifth capacitor coupled between the further resistor and the further input of the first inverter stage.

In Example 43, the subject matter of any one of Examples 40 to 42 can optionally include that the amplifier structure further includes a sixth capacitor coupled between the first inverter stage and the second inverter stage.

While the invention has been particularly shown and described with reference to specific embodiments, it should be understood by those skilled in the art that various changes in form and detail may be made therein without departing from the spirit and scope of the invention as defined by the appended claims. The scope of the invention is thus indicated by the appended claims and all changes which come within the meaning and range of equivalency of the claims are therefore intended to be embraced.

## Claims

1. An amplifier structure, comprising:
a first amplifier substructure (102) comprising a first amplifier (104) and a first filter structure (106) and configured to provide a first high frequency output signal (108) and a first low frequency output signal (110) having a frequency lower than a frequency of the first high frequency output signal (108);
a second amplifier substructure (126) comprising a second amplifier (128) and a second amplifier (130) and configured to provide a second high frequency output signal (132) and a second low frequency output signal (134) having a frequency lower than a frequency of the second high frequency output signal (132);
a first combination node configured to receive the first high frequency output signal (108) and the second low frequency output signal (134) and to provide a first amplified signal; and
a second combination node (152) configured to receive the first low frequency output signal (110) and the second high frequency output signal (132) and to provide a second amplified signal.

2. The amplifier structure of claim 1,
wherein each of the first amplifier substructure (102) and the second amplifier substructure (126) have a same structure.

3. The amplifier structure of claim 1 or 2,
wherein the first amplifier substructure (102) comprises a first transistor (112) and a second transistor (114), wherein a first controlled terminal of the first transistor (112) is coupled to a first controlled terminal of the second transistor (114), wherein a second controlled terminal of the first transistor (112) is coupled to a first terminal providing the first high frequency output signal (108), and wherein a second controlled terminal of the second transistor (114) is coupled to a second terminal providing the first low frequency output signal (110).

4. The amplifier structure of any one of claims 1 to 3,
wherein the second amplifier substructure (126) comprises a third transistor (136) and a fourth transistor (138), wherein a first controlled terminal of the third transistor (136) is coupled to a first controlled terminal of the fourth transistor (138),
wherein a second controlled terminal of the third transistor (136) is coupled to a third terminal providing the second high frequency output signal (132), and wherein a second controlled terminal of the fourth transistor (138) is coupled to a fourth terminal providing the second low frequency output signal (134).

5. The amplifier structure of claim 3,
at least one of wherein the first amplifier (104) further comprises a first cascode transistor (122) coupled to the first transistor (112) and a second cascode transistor (124) coupled to the second transistor (114), or the second amplifier (128) further comprises a third cascode transistor (146) coupled to the third transistor (136) and a fourth cascode transistor (148) coupled to the fourth transistor (138).

6. The amplifier structure of any one of claims 1 to 5,
at least one of wherein the first amplifier (104) is configured in a common gate structure or wherein the second amplifier (128) is configured in a common gate structure.

7. The amplifier structure of claim 6,
wherein the first amplifier (104) further comprises a first cascode transistor (122) coupled to the first transistor (112) and a second cascode transistor (124) coupled to the second transistor (114); and
wherein the first filter structure (106) comprises a first filter (106a) coupled between the first transistor (112) and the first cascode transistor (122) and a second filter (106b) coupled between the second transistor (114) and the second cascode transistor (124).

8. The amplifier structure of claim 6,
wherein the second amplifier (130) comprises a second filter (130a) coupled between the third transistor (136) and the third cascode transistor (146) and a fourth filter (140b) coupled between the fourth transistor (138) and the fourth cascode transistor (148).

9. The amplifier structure of claim 7,
wherein the first filter (106a) comprises a first N-path filter having a first center frequency, and
wherein the second filter (106b) comprises a second N-path filter having a second center frequency, the first center frequency being higher than the second center frequency.

10. The amplifier structure of claim 8,
wherein the second filter (130a) comprises a third N-path filter having a third center frequency, and
wherein the fourth filter (140b) comprises a fourth N-path filter having a fourth center frequency, the third center frequency being higher than the fourth center frequency.

11. The amplifier structure of any one of claims 1 to 10, further comprising:
an input circuit coupled to the first amplifier substructure (102) and the second amplifier substructure (126);
wherein the input circuit comprises a series connection of a first inverter stage (INV1) and a second inverter stage (INV2),
wherein the first inverter stage (INV1) is configured to
receive a first input voltage (VINP) of a differential input voltage pair and a second input voltage (VINN) of the differential input voltage pair;
provide an intermediate differential voltage pair to the second inverter stage (INV2);
wherein an output of the second inverter stage (INV2) is coupled to the first amplifier substructure (102) and the second amplifier substructure (126).

12. The amplifier structure of claim 11,
wherein the first inverter stage (INV1) comprises at least one feedback path from a first output of the first inverter stage (INV1) to a first input of the first inverter stage (INV1), the at least one feedback path comprising a series connection of a first source follower circuit and the first resistor;
preferably wherein the first inverter stage (INV1) further comprises a second feedback path from a second output of the first inverter stage (INV1) to a second input of the first inverter stage (INV1), the second feedback path comprising a series connection of a second source follower circuit and the second resistor.

13. The amplifier structure of any one of claims 1 to 12,
wherein the first filter structure (106) is configured to reduce the noise of the signal received by the first filter structure (106) to provide the first high frequency output signal (108) and the first low frequency output signal (110).

14. The amplifier structure of any one of claims 1 to 13,
wherein the input terminal (150) is configured to provide the first amplified signal by suppressing noise by combining the first high frequency output signal (108) and the second low frequency output signal (134); and
wherein the second combination node (152) is configured to provide the second amplified signal by suppressing noise by combining the second high frequency output signal (132) and the first low frequency output signal (110).

15. The amplifier structure of any one of claims 1 to 14,
wherein the input terminal (150) is configured to provide the first amplified signal by suppressing correlated noise generated in the first amplifier (104) and in the second amplifier (128); and
wherein the second combination node (152) is configured to provide the second amplified signal by suppressing correlated noise generated in the first amplifier (104) and in the second amplifier (128).
